Europäisches Patentamt

(19) European Patent Office

Office européen des brevets

(11) Numéro de publication: **0 027 425**
**B1**

(12) **FASCICULE DE BREVET EUROPEEN**

(45) Date de publication du fascicule du brevet: **28.09.83**

(51) Int. Cl.³: **G 07 B  13/02, G 01 R  31/36**

(21) Numéro de dépôt: **80430021.8**

(22) Date de dépôt: **03.10.80**

(54) **Procédé et dispositif pour éviter les fraudes sur le prix indiqué par l'afficheur lumineux d'un taximètre électronique et taximètre équipé d'un tel dispositif.**

(30) Priorité: **12.10.79 FR  7925736**

(43) Date de publication de la demande:
**22.04.81 Bulletin 81/16**

(45) Mention de la délivrance du brevet:
**28.09.83 Bulletin 83/39**

(84) Etats contractants désignés:
**AT BE CH DE GB IT LI SE**

(56) Documents cités:
**FR - A - 2 238 195**
**FR - A - 2 417 143**
**US - A - 3 522 481**
**US - A - 3 568 175**
**US - A - 3 809 312**
**US - A - 3 852 732**
**US - A - 4 001 777**

(73) Titulaire: **Ricard, Claude**
**10 Oliveraie G Route de Nice**
**F-13100 Aix-en-Provence (FR)**

(72) Inventeur: **Ricard, Claude**
**10 Oliveraie G Route de Nice**
**F-13100 Aix-en-Provence (FR)**

(74) Mandataire: **Azais, Henri et al,**
**c/o CABINET BEAU DE LOMENIE 14, rue Raphael**
**F-13008 Marseille (FR)**

Courier Press, Leamington Spa, England.

## Procédé et dispositif pour éviter les fraudes sur le prix indiqué par l'afficheur lumineux d'un taximètre électronique et taximètre équipé d'un tel dispositif

La présente invention a pour objet un procédé, des dispositif et des taximètres équipés de ces dispositifs pour éviter les fraudes sur le prix indiqué par l'afficheur lumineux d'un taximètre électronique.

Le secteur technique de l'invention est celui de la construction des taximètres électroniques à affichage lumineux.

Les anciens compteurs mécaniques de taxi comportant des afficheurs à rouleaux sont remplacés progressivement par des compteurs ou taximètres électroniques comportant un dispositif d'affichage lumineux du prix de la course, par exemple un dispositif à cristaux liquides ou à diodes électro-luminescentes ou tout autre dispositif d'affichage lumineux équivalent.

Un taximètre électronique est un appareil de mesure destiné à déterminer un prix payé par un client. Une qualité essentielle d'un tel appareil est que ceux qui l'utilisent ne puissent frauder en faisant payer au client un prix supérieur au prix légal.

Il est apparu que les dispositifs d'affichage lumineux des taximètres électroniques pouvaient donner lieu à des fraudes par coupure volontaire du courant d'alimentation du taximètre.

Les circuits électroniques des taximètres sont alimentés en tension continue par la batterie d'accumulateurs du véhicule tant que la tension délivrée par cette batterie est supérieure à une tension de seuil au-dessous de laquelle les circuits électroniques ne peuvent plus fonctionner normalement. Afin d'éviter des indications de prix erronées, les taximètres électroniques comportent généralement un dispositif de sécurité qui compare la tension délivrée par la batterie à une tension de référence qui correspond au seuil de sécurité au-dessous duquel les circuits électroniques risqueraient de présenter des défauts de fonctionnement. Ce dispositif de sécurité engendre un signal dès que la tension délivrée par la batterie tombe au-dessous du seuil de sécurité et interrompt le fonctionnement du taximètre. Cependant des chutes de tension accidentelles et de courte durée peuvent intervenir et interviennent au cours d'une course, par exemple si la batterie est légèrement déchargée et si le conducteur du taxi actionne le démarreur pour faire redémarer le moteur après un arrêt accidentel ou volontaire de celui-ci. De telles chutes de tension accidentelles entraînent l'extinction des afficheurs lumineux et il faut absolument qu'au retour de la tension normale, ces afficheurs reprennent le comptage à la valeur qui était comptabilisée avant l'extinction.

On rappelle que les afficheurs lumineux sont augmentés pas à pas d'une quantité finie ou incrément appelée la chute du compteur qui est par exemple de cinquante centimes. Cette chute correspond par exemple selon les tarifs appliqués à un parcours de 100 mètres ou à un temps d'attente de 50 secondes.

Ces particularités de fonctionnement des taximètres électroniques équipés d'afficheurs lumineux ont donné lieu à des fraudes. Une de ces fraudes consiste à mettre en route le compteur avant la prise en charge d'un client, pendant une durée de stationnement qui est légèrement inférieure à la durée qui correspond à une chute, de sorte que l'afficheur lumineux reste à zéro. On coupe ensuite l'alimentation électrique du taximètre que l'on rétablit au moment où le client prend place dans le taxi et où l'on manoeuvre le commutateur libre-occupé. A ce moment apparaît sur l'afficheur le prix normal de la prise en charge et, quelques secondes après, ce prix se trouve augmenté d'une chute, de sorte que l'exploitant du taxi gagne une chute au cours de chaque trajet.

Une autre fraude consiste à enregistrer un prix sur le taximètre, avant la prise en charge d'un client, puis à couper l'alimentation électrique du taximètre jusqu'au moment où un client prend place dans celui-ci, de sorte qu'à ce moment là, l'afficheur lumineux est éteint.

On rétablit l'alimentation électrique du taximètre en même temps ou juste avant que l'on manoeuvre le commutateur libre-occupé, de sorte qu'il apparaît à ce moment là sur l'afficheur lumineux un prix égal à la somme de la prise en charge et du prix frauduleusement enregistré. Un client peu attentif ne différencie pas ce prix du prix de la prise en charge qui devrait normalement s'afficher.

On connaît des dispositifs pour surveiller la tension délivrée par une batterie en vue d'éviter une décharge excessive de celle-ci. Le brevet US 3.852.732 (YORKSIE) décrit un dispositif de surveillance de la tension délivrée par une batterie qui comporte plusieurs comparateurs à seuils qui déclenchent une signalisation dès que la tension tombe au-dessous d'un seuil ainsi qu'une mesure de durée de la chute de tension. Si cette durée excède une valeur déterminée, on coupe automatiquement l'alimentation de l'un des récepteurs utilisant la tension de sortie de la batterie.

Le brevet US 3.568.175 (R. SCHWEHR) décrit également un dispositif de surveillance de la tension délivrée par une batterie. Lorsque cette tension descend au-dessous d'un seuil, on met en route une unité de temporisation qui déclenche une signalisation et une deuxième unité de temporisation qui coupe automatiquement l'alimentation de l'un des récepteurs utilisant la tension de sortie de la batterie.

Le brevet US 3.522.481 (B. TERZIC) décrit un dispositif de surveillance d'une batterie qui comporte un comparateur de tension, un premier circuit de temporisation qui déclenche une signalisation et un deuxième circuit de temporisation qui coupe automatiquement l'alimentation de l'un des récepteurs.

Tous ces documents connus concernent des dispositifs qui surveillent la tension de sortie d'une batterie en vue d'éviter une décharge excessive de celle-ci et qui actionnent, dans un premier temps, une signalisation puis qui coupent automatiquement l'alimentation de l'un des récepteurs si la durée de la chute de tension dépasse une durée déterminée et au moment même où ce dépassement a lieu.

Dans le cas d'un taximètre, une chute de tension au-dessous d'un seuil de sécurité doit entraîner une interruption du fonctionnement du taximètre afin d'éviter un fonctionnement défectueux des circuits électroniques qui conduirait à une erreur dans le prix affiché et facturé au client.

Normalement, les chutes de tension accidentelles sont de très courte durée et, lorsque la tension redevient normale, l'unité de calcul doit reprendre ses opérations au point où elles se trouvaient avant la coupure de courant.

Mais il peut y avoir des coupures de courant totales dans un but de fraude et l'objectif de l'invention est de munir les taximètres d'un dispositif logique qui est capable de faire un choix entre les coupures accidentelles de très courte durée et les coupures volontaires et frauduleuses et qui, dans ce dernier cas, remet automatiquement à zéro l'unité de calcul et l'afficheur lumineux, ce qui efface l'information enregistrée frauduleusement.

L'invention est appliquée à des taximètres électroniques du type qui comportent une unité de calcul, une mémoire et un afficheur lumineux et qui est alimenté par une source de tension continue associée à un dispositif qui comporte la tension d'alimentation du taximètre V à un seuil de sécurité Vr, lequel dispositif délivre un premier signal logique, lorsque ladite tension V descend au-dessous dudit seuil Vr, lequel premier signal déclenche la mise en mémoire de l'information contenue dans l'unité de calcul et interrompt le fonctionnement du taximètre et lequel dispositif délivre un deuxième signal logique lorsque ladite tension V redevient supérieure audit seuil Vr, lequel deuxième signal rétablit le fonctionnement du taximètre, lequel dispositif comporte, en outre, un comparateur de durée qui est actionné par ledit premier signal logique et qui compare la durée de la chute de tension à une durée de référence.

L'objectif de l'invention est atteint au moyen d'un procédé pour éviter les fraudes selon lequel, au moment où le deuxième signal logique est émis et où le fonctionnement du taximètre est rétabli, on compare la durée totale de la chute de tension à la durée de référence et:

— si la durée totale de la chute de tension a été supérieure à la durée de référence, on remet à zéro l'unité de calcul et l'afficheur lumineux;

— si la durée totale de la chute de tension a été inférieure à la durée de référence, on transfère dans l'unité de calcul l'information mise en mémoire et le fonctionnement du taximètre se poursuit.

Selon un premier mode de réalisation, un dispositif selon l'invention pour éviter les fraudes sur le prix indiqué sur l'afficheur lumineux d'un taximètre alimenté en courant par la batterie du taxi comporte un premier comparateur qui compare la tension (V) délivrée par la batterie à un seuil (Vr) et qui délivre une première tension (Vc) si la tension (V) de la batterie est supérieure audit seuil (Vr) et une deuxième tension inférieure à la première, si elle est inférieure audit seuil; comporte, en outre, un comparateur de durée qui est composé d'un condensateur (C) qui est connecté à la sortie dudit premier comparateur à travers une soupape et une résistance de charge (R1) et qui est également connecté sur une résistance de décharge (R2) et d'un deuxième comparateur de tension qui compare la tension aux bornes dudit condensateur (C) à une deuxième tension de référence (VD) intermédiaire entre lesdites première et deuxième tensions délivrées par ledit premier comparateur et une unité logique qui est connectée à la sortie dudit deuxième comparateur et qui commande la remise à zéro de l'unité de calcul et de l'afficheur lumineux lorsque la tension aux bornes dudit condensateur (C) est inférieure à ladite tension de référence (VD).

Selon un deuxième mode de réalisation, un dispositif antifraude selon l'invention comporte une source de courant auxiliaire, de faible capacité, qui alimente en courant électrique des circuits comportant:

— une horloge électronique;

— un compteur d'impulsions, de capacité déterminée, sur l'entrée duquel est connectée ladite horloge;

— un comparateur qui compare la tension délivrée par la batterie du taxi à une première tension de référence et qui délivre, sur sa borne de sortie, une première tension si la tension délivrée par la batterie est supérieure à ladite tension de référence et une deuxième tension si elle est inférieure, laquelle borne de sortie est connectée sur la borne de remise à zéro dudit compteur d'impulsions et remet le compteur à zéro sur un niveau haut;

— une mémoire qui est connectée sur la sortie dudit compteur d'impulsions et qui change d'état si le nombre d'impulsions compté par ledit compteur atteint la capacité maximale de celui-ci;

— et des circuits logiques qui sont connectés sur ladite mémoire et qui remettent à zéro ladite unité de calcul et l'afficheur lumineux chaque fois que ladite mémoire indique que ledit compteur d'impulsions a atteint sa capacité maximale, lesquels circuits logiques sont connectés sur la remise à zéro de la mémoire afin de ramener la sortie à zéro lorsque l'information mémorisée de cette dernière a été prise en compte.

L'invention a pour résultat des taximètres électroniques perfectionnés équipés d'un dispositif qui évite les fraudes sur le prix indiqué par l'afficheur lumineux de l'appareil.

Un avantage essentiel des taximètres selon l'invention réside dans le fait qu'ils réduisent les possibilités de fraude sur le prix facturé au client en case de coupure momentanée et volontaire de l'alimentation électrique du taximètre tout en conservant la reprise normale du comptage après une chute de tension de courte durée.

La description suivante se réfère aux dessins annexés qui représentent, sans aucun caractère limitatif, des exemples de réalisation de dispositifs selon l'invention.

La figure 1 est un schéma sous forme de bloc diagramme.

Les figures 2 et 3 représentent deux modes de réalisation de taximètres équipés d'un dispositif anti-fraude selon l'invention.

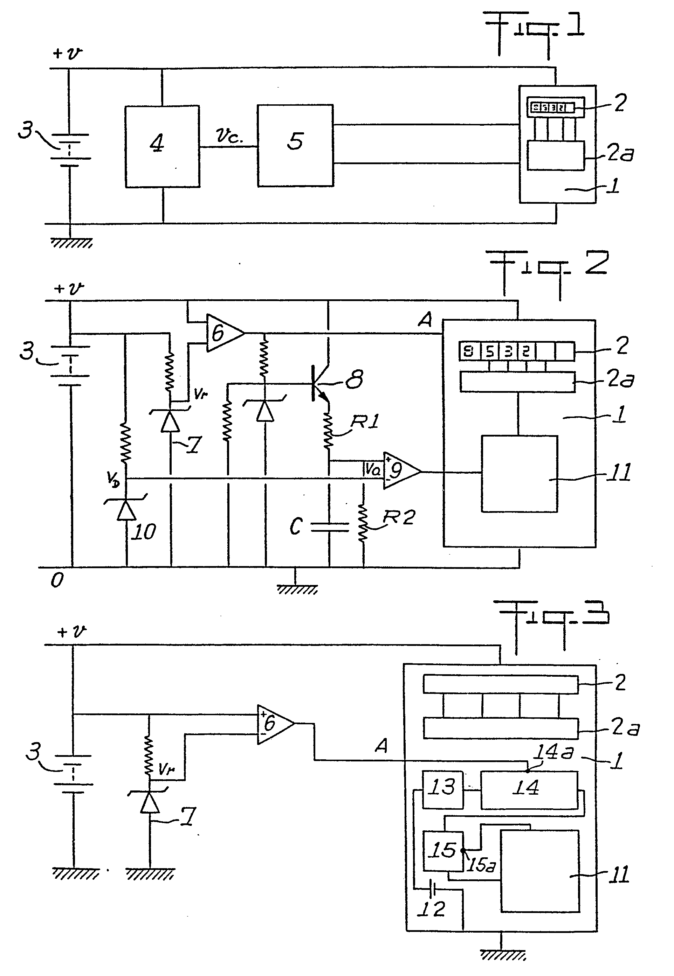

La figure 1 est un schéma qui permet d'expliquer les étapes du procédé anti-fraude qui fait l'objet de l'invention.

Le repère 1 représente un compteur de taxi ou taximètre électronique, de tout modèle connu, comportant un afficheur lumineux 2 sur lequel apparaît le prix de la course. On rappelle que ce prix est calculé par une unité de calcul 2a, qui comptabilise, soit des temps d'attente, soit des distances parcourues, en choisissant à tout instant celui des deux qui est le plus avantageux pour le taxi.

Le taximètre 1 est alimenté en courant continu par la batterie d'accumulateurs 3 du véhicule, par exemple une batterie qui délivre une tension de 12 volts.

En cas de coupure de l'alimentation électrique, ou en cas de chute de la tension d'alimentation, l'afficheur lumineux s'éteint. Si cette coupure ou cette chute de tension intervient pendant un trajet payant, lorsque l'alimentation normale du taximètre est rétablie, l'unité de calcul et l'afficheur lumineux reprennent leur fonctionnement au point où ils se trouvaient au moment de la coupure. Cette particularité des taximètres électroniques équipés d'un affichage lumineux peut donner lieu à des fraudes sur le prix affiché au moyen de coupures volontaires de l'alimentation électrique du taximètre 1.

Pour remédier à ces possibilité de fraudes, on compare au moyen d'un comparateur 4 la tension V d'alimentation du taximètre délivrée par la batterie 3 à une tension de référence Vr nettement plus faible que la tension normale. Par exemple, si la batterie 3 délivre une tension V de 12 volts, on compare à une tension de référence Vr de 6 volts. Le comparateur 4 délivre une première tension Vc tant que la tension $V > Vr$ et une deuxième tension lorsque $V < Vr$. Ces deux tensions constituent un signal logique binaire. De préférence, la deuxième tension est nulle.

La sortie du comparateur 4 est connectée sur un circuit 5 qui compare la durée pendant laquelle la tension Vc est nulle à une durée de référence qui est de l'ordre par exemple de la dizaine de secondes, c'est-à-dire nettement supérieure à la durée maxima des chutes de tension qui peuvent intervenir accidentellement au cours d'un trajet.

Lorsque la tension d'alimentation V est rétablie, le circuit 5 délivre un signal qui peut prendre deux valeurs. Si la durée pendant laquelle la tension Vc est restée nulle dépasse la durée de référence, le circuit 5 délivre un signal de remise à zéro de l'unité de comptage et de l'afficheur lumineux 2 du taximètre. Si, au contraire, la durée pendant laquelle la tension Vc est restée nulle est inférieure à la durée de référence, le signal délivré par le circuit 5 autorise la remise en marche de l'unité de comptage et de l'afficheur qui reprennent leurs opérations au point où celles-ci se trouvaient au moment de l'interruption de la tension V.

La figure 2 représente un mode de réalisation des circuits antifraude mettant en oeuvre le procédé selon l'invention.

On retrouve sur cette figure 1e taximètre 1 équipé d'un afficheur lumineux et d'une unité de comptage et de calcul 2a et 1a batterie 3 du véhicule qui délivre par exemple une tension continue V de 12 volts et qui alimente les composants électroniques du taximètre et du dispositif anti-fraude.

Le repère 6 représente un amplificateur opérationnel monté en comparateur qui compare la tension V à une tension de référence Vr qui est déterminée par la diode zéner 7. La tension de référence Vr, qui est la tension de claquage de la diode zéner, est égale par exemple au seuil de sécurité au-dessous duquel le fonctionnement des composants électroniques qui composent le taximètre risque d'être perturbé. Un tel dispositif existe généralement sur les taximètres connus. Lorsque la tension V descend au-dessous du seuil Vr, le comparateur 6 envoie sur la borne d'entrée A du taximètre une tension nulle qui interrompt le fonctionnement du taximètre et qui déclenche la mise en mémoire de l'information contenue à ce moment là dans l'unité de calcul. Lorsque la tension V redevient supérieure au seuil de sécurité Vr, le comparateur 6 délivre une tension constante qui constitue le niveau haut d'un signal binaire et provoque la remise en marche de l'unité de comptage, et donc de l'afficheur, à partir du point atteint au moment de la chute de tension V au-dessous du seuil Vr. Un tel dispositif évite des erreurs de fonctionnement du taximètre dues à une tension d'alimentation trop faible. Comme les chutes de tension accidentelles sont généralement très brèves, de l'ordre de la seconde, l'interruption du comptage pendant la durée d'une chute de tension introduit une erreur négligeable sur le prix affiché.

La sortie du comparateur 6 est connectée sur la base d'un transistor amplificateur de puissance 8 sur l'émetteur duquel on retrouve une tension qui reproduit la tension à la sortie du comparateur 6. L'émetteur du transistor 8 est connecté, à travers une résistance R1, sur un condensateur C. Le condensateur C est connecté sur une résistance de décharge R2. Le transistor 8 peut être remplacé par une diode.

Un comparateur 9 compare la tension aux bornes de C à une tension de référence $V_D$ qui est fixée par une diode Zéner 10.

Tant que la tension V est supérieure au seuil de sécurité Vr, le transistor 8 délivre une tension constante V1 et le condensateur C reste entièrement chargé sous cette tension.

Dès que la tension V devient inférieure à Vr, le transistor 8 délivre une tension nulle et le condensateur C se décharge exponentiellement à travers R2.

En fonction de la constante de temps de décharge C. R2 et de la tension constant V1, on choisit une valeur de la référence $V_D$ telle que le temps to nécessaire pour que la tension aux bornes du condensateur C devienne inférieur à $V_D$ soit supérieur à une durée déterminée, par exemple à 10 secondes, qui est une durée nettement supérieure à celle des chutes de tension accidentelles.

Ainsi, lorsque la tension V redevient supérieure au seuil Vr, selon que la durée de la chute de la tension d'alimentation du taximètre a été supérieure ou inférieure à la durée de référence choisie, la tension aux bornes du condensateur C se trouve inférieure ou supérieure à la tension de référence $V_D$ lorsque l'alimentation normale du taximètre est rétablie.

Le taximètre 1 comporte des circuits logiques 11, par exemple un microprocesseur, qui commande la mise en mémoire de l'information enregistrée sur l'unité de calcul 2a au moment de la coupure. Au retour de la tension d'alimentation V, le microprocesseur 11 interroge la sortie du comparateur 9. Si la tension aux bornes du condensateur C est supérieure à $V_D$, le microprocesseur réinitialise l'unité de calcul et l'afficheur 2 à la valeur mise en mémoire. Si, au contraire, la tension aux bornes de C est inférieure à $V_D$, on en déduit qu'il s'agit d'une coupure volontaire de la tension d'alimentation V et le microprocesseur commande la remise à zéro de l'unité de calcul. Grâce à ce dispositif, si le chauffeur de taxi fait tourner le compteur avant de prendre un client en charge puis coupe volontairement l'alimentation du taximètre pour que l'afficheur 2 soit éteint au moment où le client rentre dans le taxi et rétablit ensuite l'alimentation du taximètre immédiatement avant d'appuyer sur le bouton de prise en charge, le prix enregistré avant la coupure volontaire du courant est effacé.

Après le retour de la tension d'alimentation du taximètre, le microprocesseur 11 met un certain laps de temps très bref, de l'ordre du centième de seconde, pour interroger la sortie du comparateur 9 et il faut éviter que pendant ce laps de temps la charge du condensateur C ne puisse remonter rapidement au-dessus de la tension $V_D$. Pour cette raison, la constante de temps de charge R1.C doit être relativement grande, de l'ordre de la seconde ou plus. Elle ne doit pas être trop faible en comparaison du laps de temps de réaction du comparateur 9 et du microprocesseur 11.

La figure 3 représente un autre mode de réalisation d'un dispositif pour la mise en oeuvre du procédé anti-fraude selon l'invention. Le repère 1 représente un taximètre équipé d'un afficheur lumineux 2 et d'une unité de comptage et de calcul 2a. Le repère 3 représente la batterie du véhicule qui délivre une tension continue V qui alimente le taximètre en marche normale. Les repères 6, 7 et 11 et la borne A représentent des parties homologues à celles de la figure 2.

Dans cet exemple le taximètre comporte une source auxiliaire 12 de courant continu de faible capacité par exemple une pile ou une petite batterie qui est incorporée au taximètre et qui sert à assurer le fonctionnement des unités essentielles en cas de coupure de la tension V. Plusieurs types de taximètres connus comportent une source auxiliaire 12 qui sert notamment à garder en mémoire l'information enregistrée dans l'unité de calcul au moment où se produit une chute accidentelle de la tension d'alimentation V.

La source 12 alimente les composants du dispositif anti-fraude. Ces composants sont une horloge électronique 13, un compteur d'impulsions 14 qui est connecté sur la source 13 et qui compte les impulsions émises par celle-ci et une mémoire 15, par exemple une bascule, qui est connectée à la sortie du compteur 14. Le compteur 14 a une capacité de comptage maxima qui correspond à une durée de référence. Par exemple si l'horloge 13 oscille à une fréquence de 1 KHz et que l'on ait choisi une durée de référence de 10 secondes, la capacité maxima du compteur 14 est égale à 10.000. La sortie du compteur 14 change d'état lorsque le compteur a compté 10.000 impulsions successives et conserve cet état jusqu'à la prochaine remise à zéro quel que soit le nombre d'impulsions reçues par le compteur au delà de 10.000. La borne 14a de remise à zéro du compteur 14 est connectée sur la borne A, c'est-à-dire sur la sortie du comparateur 6.

Le fonctionnement est le suivant.

Tant que la tension d'alimentation V est normale, c'est-à-dire supérieure au seuil de sécurité Vr, le comparateur 6 émet une tension constante qui maintient le compteur 14 à zéro.

Si la tension V chute au-dessous du seuil Vr, le comparateur 6 coupe la tension d'alimentation V du taximètre. Immédiatement le microprocesseur 11, qui est programmé pour cela, met en mémoire l'information contenue dans l'unité de calcul. En même temps, l'ordre de remise à zéro du compteur 14 disparaît et celui-ci se met à compter les impulsions émises par l'horloge 13. Dès que la tension redevient supérieure à Vr, le compteur 14 est remis à zéro et le microprocesseur 11, qui est programmé pour celà, ou tout autre circuit logique équivalent, interroge la mémoire 15.

Si la mémoire 15 a changé d'état, c'est-à-dire si le compteur 14 a atteint sa capacité maximale, le microprocesseur 11 remet à zéro l'unité de calcul 2a et l'afficheur 2. Si la mémoire 15 n'a pas changé d'état, le microprocesseur 11 remet en route l'unité de calcul et de comptage 2a qui reprend ses opérations à partir de la valeur mise en mémoire lors de la coupure de la tension V. Le microprocesseur 11 est connecté à la borne 15a de remise à zéro de la mémoire 15 et il remet celle-ci à l'état initial après l'avoir interrogée.

Les dispositifs anti-fraude selon l'invention peuvent être incorporés aux taximètres ou associés à des taximètres électroniques existant qui n'en comportaient pas.

Afin d'éviter une possibilité de fraude qui consisterait à couper plusieurs fois de suite la tension V d'alimentation du taximètre pendant une durée inférieure à la durée de référence et à la rétablir aussitôt, on choisit une constante de temps de charge $R1.C$ suffisamment élevée, de telle sort que si l'intervalle de temps qui sépare le rétablissement de la tension de la coupure suivante est inférieur à cette constante de temps, le condensateur C n'est pas entièrement chargé et on atteint finalement aux bornes du condensateur C la tension $V_D$ qui provoque la remise à zéro du taximètre.

## Revendications

1. Procédé pour éviter les fraudes sur le prix de la course indiqué par un taximètre électronique (1) du type qui comporte une unité de calcul (2a), une mémoire et un afficheur lumineux (2) et qui est alimenté par une source de tension continue (3) associée à un dispositif (4) qui compare la tension d'alimentation du taximètre (V) à un seuil de sécurité (Vr), lequel dispositif délivre un premier signal logique, lorsque ladite tension (V) descend au-dessous dudit seuil (Vr), lequel premier signal déclenche la mise en mémoire de l'information contenue dans l'unité de calcul et interrompt le fonctionnement du taximètre et lequel dispositif délivre un deuxième signal logique lorsque ladite tension (V) redevient supérieure audit seuil (Vr), lequel deuxième signal rétablit le fonctionnement du taximètre, lequel dispositif comporte, en outre, un comparateur de durée qui est actionné par ledit premier signal logique et qui compare la durée de la chute de tension à une durée de référence, caractérisé en ce que, au moment où le deuxième signal logique est émis et où le fonctionnement du taximètre est rétabli, on compare la durée totale de la chute de tension à la durée de référence et:

— si la durée totale de la chute de tension a été supérieure à la durée de référence, on remet à zéro l'unité de calcul (2a) et l'afficheur lumineux (2);

— si la durée totale de la chute de tension a été inférieure à la durée de référence, on transfère dans l'unité de calcul l'information mise en mémoire et le fonctionnement du taximètre se poursuit.

2. Dispositif pour éviter les fraudes sur le prix de la course indiqué par un taximètre électronique (1) du type qui comporte une unité de calcul (2a) avec mémoire et un afficheur lumineux (2) et qui est alimenté par la batterie (3) du taxi associée à un dispositif qui comporte un premier comparateur (4, 6) qui compare la tension (V) délivrée par la batterie (3) à un seuil (Vr) et qui délivre une première tension (Vc) si la tension (V) de la batterie est supérieure audit seuil (Vr) et une deuxième tension inférieure à la première, si elle est inférieure audit seuil, caractérisé en ce qu'il comporte, en outre, un comparateur de durée (5) qui est composé d'un condensateur (C) qui est connecté à la sortie dudit premier comparateur (6) à travers une soupape (8) et une résistance de charge (R1) et qui est également connecté sur une résistance de décharge (R2) et d'un deuxième comparateur de tension (9) qui compare la tension aux bornes dudit condensateur (C) à une deuxième tension de référence (VD) intermédiaire entre lesdites première et deuxième tensions délivrées par ledit premier comparateur et une unité logique (11) qui est connectée à la sortie dudit deuxième comparateur et qui commande la remise à zéro de l'unité de calcul et de l'afficheur lumineux lorsque la tension aux bornes dudit condensateur (C) est inférieure à ladite tension de référence (VD).

3. Dispositif pour éviter les fraudes sur le prix de la course indiquée par un taximètre électronique (1) qui est alimenté en courant électrique par la batterie (3) du taxi et qui comporte une unité de calcul (2a) et un afficheur lumineux (2) du prix de la course, caractérisé en ce qu'il comporte une source d'alimentation auxiliaire (12) qui alimente des circuits comportant:

— une horloge électronique (13);

— un compteur d'impulsions (14) de capacité déterminée sur l'entrée duquel est connectée ladite horloge (13);

— un comparateur (6) qui compare la tension (V) délivrée par la batterie du taxi à une première tension de référence (Vr) et qui délivre, sur sa borne de sortie, une première tension si la tension délivrée par la batterie est supérieure à ladite tension de référence et une deuxième tension si elle est inférieure, laquelle borne de sortie est connectée sur la borne (14a) de remise à zéro dudit compteur d'impulsions (14);

— une mémoire (15) qui est connectée sur la sortie dudit compteur d'impulsions (14) et qui change d'état si le nombre d'impulsions compté par ledit compteur atteint la capacité maximale de celui-ci;

— et des circuits logiques (11) qui sont connectés sur ladite mémoire et qui remettent à zéro ladite unité de calcul (2a) et l'afficheur lumineux (2) chaque fois que ladite mémoire (15) indique que ledit compteur d'impulsions a atteint sa capacité maximale, lesquels circuits logiques sont connectés sur la remise à zéro (15a) de la mémoire.

4. Dispositif selon l'une quelconque des revendications 2 et 3, caractérisé en ce que ladite première tension de référence (Vr) est égale au seuil de sécurité de bon fonctionnement des circuits électroniques du taximètre.

5. Dispositif selon l'une quelconque des revendications 2 à 4, caractérisé en ce que le premier comparateur de tension (6) est celui qui est utilisé habituellement pour arrêter l'unité de calcul en cas de baisse de la tension d'alimentation V au-dessous du seuil (Vr) de sécurité de bon fonctionnement des circuits électroniques du taximètre.

6. Taximètre électronique (1) comportant une unité de calcul (2a) et un afficheur lumineux (2), caractérisé en ce qu'il comporte, en outre, un dispositif anti-fraude selon l'une quelconque des revendications 2 à 5.

**Patentansprüche**

1. Verfahren zur Vermeidung von Betrügereien an dem von einem elektronischen Taxameter (1) angezeigten Fahrpreis, wobei das Taxameter ein Rechenwerk (2a), einen Speicher und eine Leuchtanzeige (2) umfaßt und von einer Gleichspannungsquelle (3) gespeist wird, die mit einer Vorrichtung (4) zum Vergleichen der Speisespannung (V) des Taxameters mit einer Sicherheitsschwelle (Vr) verbunden ist, welche Vorrichtung ein erstes logisches Signal abgibt, wenn die Spannung (V) unter die Schwelle (Vr) absinkt, wobei das erste Signal das Speichern der im Rechenwerk enthaltenen Informationen auslöst und den Betrieb des Taxameters unterbricht, und welche Vorrichtung ein zweites logisches Signal abgibt, wenn die Spannung (V) die Schwelle (Vr) überschreitet, wobei das zweite Signal den Betrieb des Taxameters wieder herstellt, welche Vorrichtung weiters einen Dauerkomparator umfaßt, der durch das erste logische Signal in Gang gesetzt wird und die Dauer des Spannungsabfalls mit einer Referenzdauer vergleicht, dadurch gekennzeichnet, daß bei Abgabe des zweiten logischen Signals bzw. Wiederherstellen des Betriebs des Taxameters die Gesamtdauer des Spannungsabfalls mit der Referenzdauer verglichen wird, und,

— wenn die Gesamtdauer des Spannungsabfalls länger als die Referenzdauer gewesen ist, das Rechenwerk (2a) und die Leuchtanzeige (2) auf null gestellt werden;

— wenn die Gesamtdauer des Spannungsabfalls geringer als die Referenzdauer gewesen ist, die im Speicher gespeicherte Information in das Rechenwerk eingegeben wird und das Taxameter seinen Betrieb wieder aufnimmt.

2. Vorrichtung zur Vermeidung von Betrügereien an dem von einem elektronischen Taxameter (1) angezeigten Fahrpreis, welches ein Rechenwerk (2a) mit Speicher und eine Leuchtanzeige (2) umfaßt und von der Batterie (3) des Taxis gespeist wird, die mit einer Vorrichtung verbunden ist, welche einen ersten Komparator (4, 6) umfaßt, der die von der Batterie (3) abgegebene Spannung (V) mit einer Schwelle (Vr) vergleicht und eine erste Spannung (Vc) abgibt, wenn die Spannung (V) der Batterie höher als die Schwelle (Vr) ist und eine zweite Spannung niedriger als die erste, wenn sie niedriger als die Schwelle ist, dadurch gekennzeichnet, daß sie weiters einen Dauerkomparator (5) aufweist, der gebildet ist durch einen über ein Ventil (8) und einen Ladewiderstand (R1) mit dem Ausgang des ersten Komparators (6) verbundenen Kondensator (C), welcher auch an einen Entladewiderstand (R2) angeschlossen ist, und einen zweiten Spannungskomparator (9), der die Spannung an den Klemmen des Kondensators (C) mit einer zweiten, zwischen der ersten und zweiten, vom ersten Komparator gelieferten Spannung angelegten Referenzspannung (VD) vergleicht, und eine logische Einheit (11), die an den Ausgang des zweiten Komparators angeschlossen ist und die Nullrückstellung des Rechenwerks und die Leuchtanzeige steuert, wenn die Spannung an den Klemmen des Kondensators (C) niedriger als die Referenzspannung (VD) ist.

3. Vorrichtung zur Vermeidung von Betrügereien an dem von einem elektronischen Taxameter (1) angezeigten Fahrpreis, welches von der Batterie (3) des Taxis mit elektrischem Strom gespeist wird und ein Rechenwerk (2a) und eine Leuchtanzeige (2) für den Fahrpreis umfaßt, dadurch gekennzeichnet, daß sie weiters eine Hilfsspeisequelle (12) umfaßt, die Schaltkreise mit:

— einer elektronischen Uhr (13);

— einem Impulszähler (14) bestimmter Kapazität, an dessen Eingang die Uhr (13) angeschlossen ist;

— einem Komparator (6), der die von der Batterie des Taxis gelieferte Spannung (V) mit einer ersten Referenzspannung (Vr) vergleicht und an seiner Ausgangsklemme eine erste Spannung abgibt, wenn die von der Batterie gelieferte Spannung höher als die Referenzspannung ist, und eine zweite Spannung, wenn diese niedriger ist, wobei die Ausgangsklemme an die Klemme (14a) der Nullrückstellung des Impulszählers (14) angeschlossen ist;

— einem Speicher (15), der an den Ausgang des Impulszählers (14) angeschlossen ist und den Status ändert, wenn die Anzahl der vom Zähler gezählten Impulse die maximale Kapazität desselben erreicht;

— logischen Schaltkreisen (11), die an den Speicher angeschlossen sind und das Rechenwerk (2a) und die Leuchtanzeige (2) auf Null rückstellen, sooft der Speicher (15) anzeigt, daß der Impulszähler seine maximale Kapazität erreicht hat, wobei die logischen Schaltkreise mit der Nullrückstellung (15a) des Speichers verbunden sind; speist.

4. Vorrichtung nach einem der Ansprüche 2 und 3, dadurch gekennzeichnet, daß die erste Referenzspannung (Vr) gleich der Sicherheitsschwelle für ein gutes Funktionieren der elektronischen Schaltkreise des Taxameters ist.

5. Vorrichtung nach einem der Ansprüche 2 bis 4, dadurch gekennzeichnet, daß der erste Spannungskomparator (6) jener ist, der gewöhnlich zum Stoppen des Rechenwerks im Fall einer niedrigen Speisespannung V unter der Sicherheitsschwelle (Vr) für ein gutes Funktionieren der elektronischen Schaltkreise des Taxameters verwendet wird.

6. Elektronisches Taxameter (1) mit einem Rechenwerk (2a) und einer Leuchtanzeige (2), dadurch gekennzeichnet, daß es weiters eine Antibetrugsvorrichtung nach einem der Ansprüche 2 bis 5, umfaßt.

## Claims

1. Method to prevent any frauds in the display of taxi fares on an electronic taximeter (1) of the type comprising a calculating unit (2a), a memory and a luminous display means (2) and being supplied by a direct current voltage source (3) associated to means (4) for comparing the voltage fed to the taximeter (V) with a safety threshold (Vr), said means delivering a first logic signal when the said voltage (V) goes down below said threshold (Vr), which first signal initiates the reading in of the information contained in the calculation unit and interrupts the operation of the taximeter and said means delivering a second logic signal when the said voltage (V) goes up again above said threshold (Vr) which second signal restores the taximeter to operation, and said means further comprising a time comparator which is actuated by said first logic signal and which compares the time in which the pressure drops with a reference time, characterised in that, at the time when the second logic signal is delivered and when the taximeter starts working again, the total duration of the pressure drop is compared to the reference time and:
— if the total duration of the pressure drop is more than the reference time, the calculating unit (2a) and the luminous display (2) are reset to zero;
— if the total duration of the pressure drop is less than the reference time, the information read into the memory is transferred to the calculating unit and the taximeter continues to operate.

2. Device to prevent any frauds in the display of taxi fares on an electronic taximeter (1) of the type comprising a calculation unit (2a) with memory and a luminous display (2) and which is powered by the battery (3) of the taxi associated to means comprising a first comparator (4, 6) which compares the voltage (V) delivered by the battery (3) to a threshold (Vr) and which delivers a first voltage (Vc) if voltage (V) of the battery is greater than said threshold (Vr) and a second tension less than the first, if it is less than said threshold, characterised in that it further comprises a time comparator (5) which is composed of a capacitor (C) connected to the output of the first comparator (6) through a valve (8) and a load resistor (R1) and which is also connected to a discharge resistor (R2) and of a second voltage comparator (9) which compares the voltage at the terminals of said capacitor (C) to a second reference voltage (VD) which is in-between the said first and second voltages delivered by the first comparator and a logic unit (11) which is connected to the output of the said second comparator and which controls the re-setting to zero of the calculation unit and of the luminous display when the voltage at the terminals of said capacitor (C) is less than said reference voltage (VD).

3. Device to prevent any frauds in the display of taxi fares on an electronic taximeter (1) which is fed electrical power by the battery (3) of the taxi and which comprises a calculation unit (2a) and a luminous display (2) for displaying the fares, characterised in that it comprises an auxiliary supply source (12) supplying circuits which comprises:
— an electronic clock (13);
— a pulse counter (14) of predetermined capacity on the input of which is connected the said clock (13);
— a comparator (6) which compares the voltage (V) delivered by the battery of the taxi to a first reference voltage (Vr) and which delivers on its output terminal, a first voltage if the voltage delivered by the battery is higher than the said reference voltage and a second voltage if it is lower, said output terminal being connected on the terminal (14a) used for resetting to zero the said pulse counter (14);
— a memory (15) which is connected to the output of said pulse counter (14) and which changes condition if the number of pulses counted by said counter reaches the maximum capacity thereof;
— and logic circuits (11) which are connected to the said memory and which reset to zero the said calculation unit (2a) and the luminous display (2) every time said memory (15) indicates that the said pulse counter has reached its maximum capacity, said logic circuits being connected to the resetting-to-zero means (15a) of the memory.

4. Device according to any one of claims 2 and 3, characterised in that the first reference voltage (Vr) is equal to the safety threshold for good operation of the electronic circuits of the taximeter.

5. Device according to any one of claims 2 to 4, characterised in that the first voltage comparator (6) is the one normally used to stop the calculation unit in case of a drop in the supply voltage (V) to below the safety threshold (Vr) for good operation of the electronic circuits of the taximeter.

6. Electronic taximeter (1) comprising a calculation unit (2a) and a luminous display (2), characterised in that it further comprises an anti-fraud device according to any one of claims 2 to 5.

0 027 425

Fig. 1

Fig. 2

Fig. 3